Europäisches Patentamt

European Patent Office

Office européen des brevets

(19)

(11) Numéro de publication : **0 434 528 A1**

(12)

# DEMANDE DE BREVET EUROPEEN

(21) Numéro de dépôt : 90403603.5

(22) Date de dépôt : 14.12.90

(51) Int. Cl.⁵ : **H01L 33/00, H01S 3/25, H01S 3/085**

(30) Priorité : 22.12.89 FR 8917087

(43) Date de publication de la demande :
26.06.91 Bulletin 91/26

(84) Etats contractants désignés :
DE GB NL

(71) Demandeur : THOMSON-CSF
51, Esplanade du Général de Gaulle
F-92800 Puteaux (FR)

(72) Inventeur : Blondeau, Robert,
THOMSON-CSF SCPI Cédex 67
F-92045 Paris la Défense (FR)
Inventeur : Bourbin, Yannic
THOMSON-CSF SCPI Cédex 67
F-92045 Paris la Défense (FR)
Inventeur : Rondi, Daniel
THOMSON-CSF SCPI Cédex 67
F-92045 Paris la Défense (FR)

(74) Mandataire : Guérin, Michel et al
THOMSON-CSF SCPI
F-92045 PARIS LA DEFENSE CEDEX 67 (FR)

(54) Procédé de réalisation d'un dispositif optoélectronique amplificateur, dispositif obtenu par ce procédé, et applications à des dispositifs optoélectroniques divers.

(57)    L'invention concerne notamment un procédé de réalisation d'un amplificateur optique selon lequel on réalise un empilement de couches suivantes par épitaxie :
- couche guidante 3,
- couche d'arrêt d'attaque chimique 4,
- couche guidante 5,
- couche d'arrêt d'attaque chimique 6,
- couche active 7,
- couche de confinement 8,
- couche de contact 9.
Ensuite, on procède à la gravure dans ces couches d'au moins un élément amplificateur (couches 7, 8 et 9) puis d'un guide optique situé sous cet élément amplificateur (couches 3, 4, 5).
Applications : Réalisation de dispositifs optoélectroniques tels que modulateurs, commutateurs, répartiteurs, etc...

FIG_6

EP 0 434 528 A1

## PROCEDE DE REALISATION D'UN DISPOSITIF OPTOELECTRONIQUE AMPLIFICATEUR, DISPOSITIF OBTENU PAR CE PROCEDE ET APPLICATIONS A DES DISPOSITIFS OPTOELECTRONIQUES DIVERS

L'invention concerne un procédé de réalisation d'un dispositif optoélectronique amplificateur et un dispositif obtenu par ce procédé. Notamment, elle concerne un dispositif comprenant un amplificateur optique intégré monolithiquement avec un guide d'onde ainsi que son procédé de réalisation. Elle concerne également l'application d'un tel amplificateur à des dispositifs optoélectroniques tels que commutateurs, modulateurs, répartiteurs.

Un effort de recherches de plus en plus important se développe depuis quelques années dans le domaine des amplificateurs optiques, soit sur fibres optiques dopées, soit sur matériaux semiconducteurs.

Concernant les amplificateurs optiques à semiconducteurs, plusieurs applications sont envisagées pour les télécommunications par fibres optiques. En effet, ils pourraient être utilisés :

    – soit à l'émission en tant que "booster",

    – soit en ligne pour remplacer avantageusement les répéteurs classiques et augmenter ainsi la portée de la liaison,

    – soit à la réception comme préamplificateurs.

Cependant, une des applications les plus prometteuses concerne l'intégration monolithique d'amplificateurs avec d'autres fonctions de l'optique, tels que modulateurs, commutateurs et distributeurs. Ces amplificateurs permettraient ainsi de compenser les pertes d'insertions et de réaliser ainsi des dispositifs très complexes à pertes réduites, voire nulles.

Un des problèmes majeurs concernant la fabrication d'amplificateurs optiques, discrets ou intégrés, est de pouvoir obtenir de très faibles coefficients de réflexion aux faces de sortie des amplificateurs, ceci afin d'éviter un comportement de type résonant lié à la cavité Fabry-Perot formée par ces faces de sortie. Jusqu'à présent, un des moyens d'obtenir de faibles coefficients de réflexion était de réaliser des couches minces diélectriques anti-réfléchissantes difficiles à contrôler et peu reproductibles.

Les documents suivants décrivent une solution permettant de réduire la réflexion aux faces de sortie par la réalisation de structures de type "fenêtres".

    – N.A.— OLSSON et al. : "Polarization independant optical amplifier with buried facets" Electronics Letters—Vol. 25— n° 16— p. 1048-1049 du 3 août 1989.

    – I. CHA et al : "1,5 Band traveling wave semiconductor optical amplifier with window facet structure"— l00C'89 (proceedings), July 18 21, 1989 KOBE— JAPAN.

Concernant l'intégration d'un amplificateur optique avec d'autres fonctions d'optique, un exemple récent consistant en l'intégration monolithique de 3 lasers DFB (DFB = Distributed Feed-back ou résonateur distribué), d'un multiplexeur et d'un amplificateur en sortie a été décrit dans le document suivant :

    U. KOREN et al. : "An Integrated Tunable light Sources with Extended Tunable Range". 100C'89 (proceeding), July 18-21, 1989 KOBE-JAPAN.

L'invention concerne une structure comprenant un amplificateur optique intégré avec un guide d'onde passif. Cette structure a permis d'obtenir un gain fibre à fibre de l'ordre de 3 à 4 dB, ce qui démontre sa potentialité pour la réalisation de dispositifs à pertes compensées.

De plus, cette structure présente l'avantage, outre l'intégration monolithique de 2 fonctions optiques, de pouvoir obtenir de très faibles coefficients de réflexion aux faces de sortie. En effet, la structure constituant le guide d'onde passif peut être optimisée de manière à réduire considérablement le coefficient de réflexion modal.

De plus, l'invention concerne un procédé de réalisation d'une nouvelle structure, plus prometteuse, et qui fait appel à l'épitaxie localisée de couches semi-isolantes par MOCVD.

C'est pourquoi l'invention concerne un procédé de réalisation d'un dispositif optoélectronique amplificateur caractérisé en ce qu'il comporte les étapes suivantes :

    a) une étape d'épitaxie sur un substrat des couches suivantes :

        – une couche de confinement optique ;

        – une première couche guidante optique en matériau transparent à la longueur d'onde à amplifier ;

        – une première couche d'arrêt d'attaque chimique ;

        – une deuxième couche guidante optique ;

        – une couche active dont le matériau présente un maximum de courbe de gain pour l'énergie de l'onde à amplifier ;

        – une couche de confinement optique ;

        – une couche de contact

    b) une première étape de gravure d'au moins un élément amplificateur dans la couche active, la couche de confinement et la couche de contact ;

    c) une deuxième étape de gravure d'au moins un guide optique situé sous l'élément amplificateur, cette gravure se faisant dans la deuxième couche guidante optique ;

    d) une étape de dépôt d'un matériau semi-isolant sur la structure ;

    e) une étape de réalisation d'un contact électrique sur la partie supérieure de la couche de contact.

Elle concerne également un amplificateur optique caractérisé en ce qu'il comporte un guide d'onde de largeur de bande interdite supérieure à l'énergie de l'onde à amplifier, ainsi qu'un élément amplificateur de dimensions limitées, situé sur une zone du guide d'onde et réalisé en un matériau dont le maximum de la courbe de gain correspond à l'énergie de l'onde propagée.

Enfin, elle concerne l'application du procédé à la réalisation de dispositifs optoélectroniques.

Notamment elle concerne un procédé de réalisation d'un modulateur appliquant le procédé précédent, caractérisé en ce qu'il comporte avant l'étape de dépôt du matériau semi-isolant sur la structure, une étape de réalisation d'au moins une électrode et des moyens de connexions électriques à cette électrode de façon à permettre l'application d'un champ électrique au guide d'onde.

Elle également un procédé de réalisation d'un commutateur appliquant également le procédé précédent, caractérisé en ce qu'il comporte la réalisation d'au moins deux guides d'ondes comportant des portions de couplage et la réalisation dans ces portions de couplage d'électrodes permettant l'application d'un champ électrique, un élément amplificateur étant réalisé au moins sur un des guides d'onde.

Elle concerne aussi un procédé de réalisation d'un répartiteur appliquant également le procédé précédent, caractérisé en ce qu'il comporte la réalisation de plusieurs guides d'onde agencés en "Y", un élément amplificateur pouvant être réalisé sur chaque branche du "Y".

Les différents objets et caractéristiques de l'invention apparaîtront dans la description qui va suivre et des figures annexées qui représentent :

– les figures 1 à 4, différentes étapes du procédé selon l'invention,

– la figure 5, une vue de dessus, du dispositif selon l'invention,

– la figure 6, une vue en perspective et en coupe partielle du dispositif selon l'invention,

– les figures 7 et 8, des exemples d'applications de l'invention à la réalisation de dispositifs optoélectroniques.

Concernant l'intégration, l'idée de base de l'invention consiste essentiellement à ajouter, sur un guide d'onde prédéfini, une ou plusieurs couches de compositions adaptées de manière à former une structure de guide à coeur composite. Afin de mettre en oeuvre cette idée, l'invention concerne un procédé de réalisation d'une telle structure.

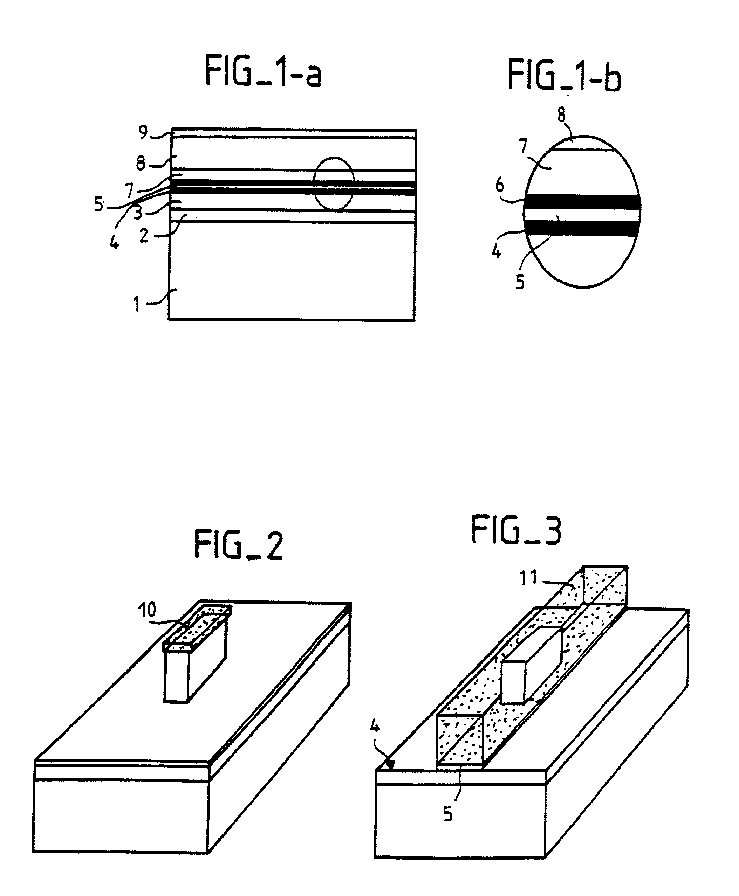

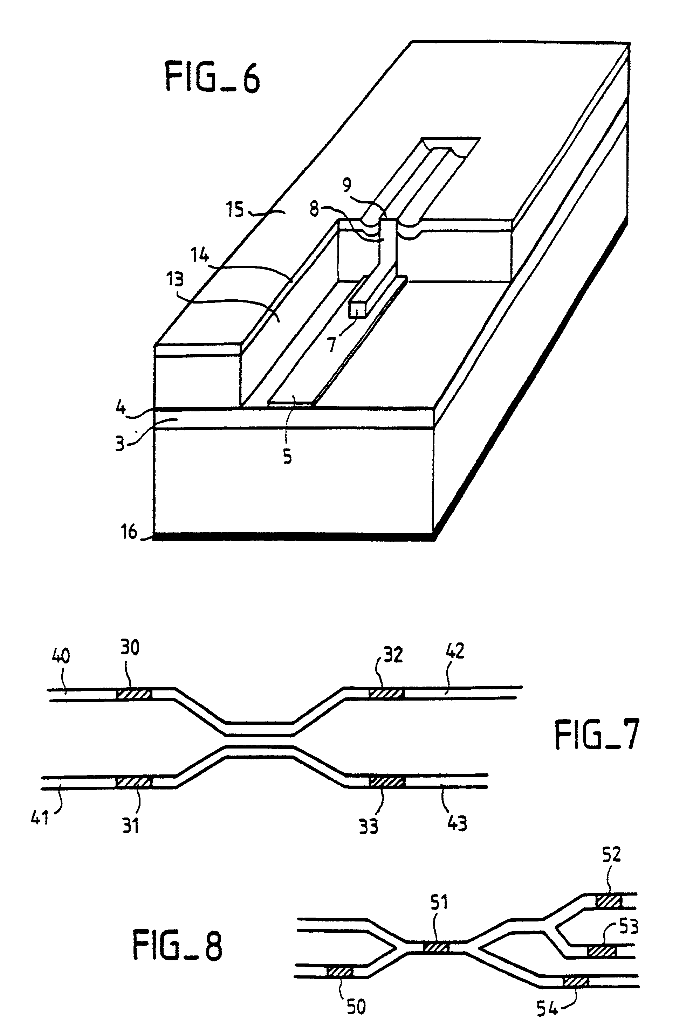

Les différentes étapes de ce procédé de réalisation sont décrites ci-après en se référant aux figures 1 à 4 :

Une première épitaxie est effectuée sur un substrat 1 en InP de type N et comporte les couches suivantes :

– une couche de confinement 2 en InP dopée de type N et d'épaisseur $e_2$.

– une couche guidante 3, d'épaisseur $e_3$, et adaptée en composition de manière à former, avec les autres couches, un guide d'onde transparent à la longueur d'onde de propagation (par exemple $\lambda_g$ (3) 1.3 µm pour une longueur d'onde guidée à $\lambda$ = 1.5 µm). Le matériau de cette couche doit donc avoir une largeur de bande interdite supérieure à l'énergie de l'onde propagée (à amplifier).

– une couche d'arrêt d'attaque chimique 4 en InP et d'épaisseur $e_4$ qui peut être très faible (10 nm).

– une couche guidante 5 d'épaisseur $e_5$ qui peut être très faible (~ 20 nm) et qui servira au confinement latéral après gravure du ruban. Cette couche sera éventuellement simmilaire en composition à la couche 3. Il est important de noter que le guide formé par gravure d'un ruban dans cette couche sera un guide à faible saut d'indice (~ $10^{-3}$) tel que décrit dans la demande de brevet français n° 86 04523.

– une seconde couche d'arrêt d'attaque chimique 6, d'épaisseur $e_6$ qui peut être faible (~ 10 µm).

– une couche active 7 d'épaisseur $e_7$ servant à l'amplification et dont la composition est adaptée à la longueur d'onde de propagation c'est-à-dire dans notre cas $\lambda_g$ (7) = 1.5 µm). Plus précisément, le matériau de cette couche active 7 est choisi de façon à ce que le maximum de courbe de gain corresponde à l'énergie de l'onde à amplifier.

– une couche de confinement 8, d'épaisseur $e_8$ de type P qui peut être en InP ou en quaternaire avec une composition correspondant à une longueur d'onde plus faible que celle de propagation (par exemple $\lambda_g$ (8) = 1.3 et 1.1 µm).

– enfin, une couche de contact 9 dopée $p^+$ et d'épaisseur $e_9$.

A l'issue de l'épitaxie de ces différentes couches sur le substrat 1, on obtient une structure telle que représentée par la figure 1a et dont la figure 1b donne un détail agrandi de la couche guidante 5 et des couches d'arrêts d'attaque chimique.

Ensuite, comme cela est représenté en figure 2, on procède à la gravure d'un élément de façon à délimiter la zone active d'un élément amplificateur. Pour cela, on réalise un masque 10 de diélectrique dont les dimensions déterminent les dimensions de l'élément amplificateur et on réalise la gravure dans les couches 7 et 9 précédemment décrites jusqu'à la couche d'arrêt 6. La largeur du ruban (10) est choisie de façon à conserver un guide monomode. Dans notre exemple de réalisation il sera de l'ordre de 1 micromètre de large, pour une longueur d'environ 500 micromètres.

Ensuite, comme cela est représenté en figure 3, on procède à la gravure d'un guide d'onde situé en-dessous de l'élément amplificateur précédemment gravé. Pour cela, on réalise un masque de résine 11 ayant les dimensions du guide d'onde à obtenir et englobant l'élément amplificateur précédent. Il est à noter que le masque diélectrique 10 précédent est conservé lors de cette phase. On procède donc à la gravure du guide d'onde dans les couches 5 et 6, en utilisant les attaques chimiques sélectives jusqu'à la couche d'arrêt d'attaque chimique 4.

La largeur du guide d'onde est optimisée de façon à ce que le guide d'onde obtenu soit monomode.

Au cours d'une étape suivante, l'ensemble de la structure est ensuite enterrée pour en permettre le fonctionnement et pour localiser l'injection électrique, nécessaire au fonctionnement, uniquement dans la zone d'amplification. Cette étape est réalisée par épitaxie en conservant le masque de diélectrique 10 ayant servi à graver le ruban de l'amplificateur, et comporte 2 couches 13 et 14 en matériau InP. La couche 13 est une couche de type semi-isolant (dopée Fer pour InP) et la deuxième couche 14 est de type dopé $N^+$. Cette dernière a pour rôle de bloquer une éventuelle diffusion d'impuretés dopantes dans la couche semi-isolante lors de la réalisation du contact ohmique.

Enfin, après avoir enlevé le masque de diélectrique 10, les dépôts de contacts ohmiques 15 et 16 sont réalisés. Il faut noter que le contact ohmique supérieur 15 peut être localisé uniquement sur la zone amplificatrice.

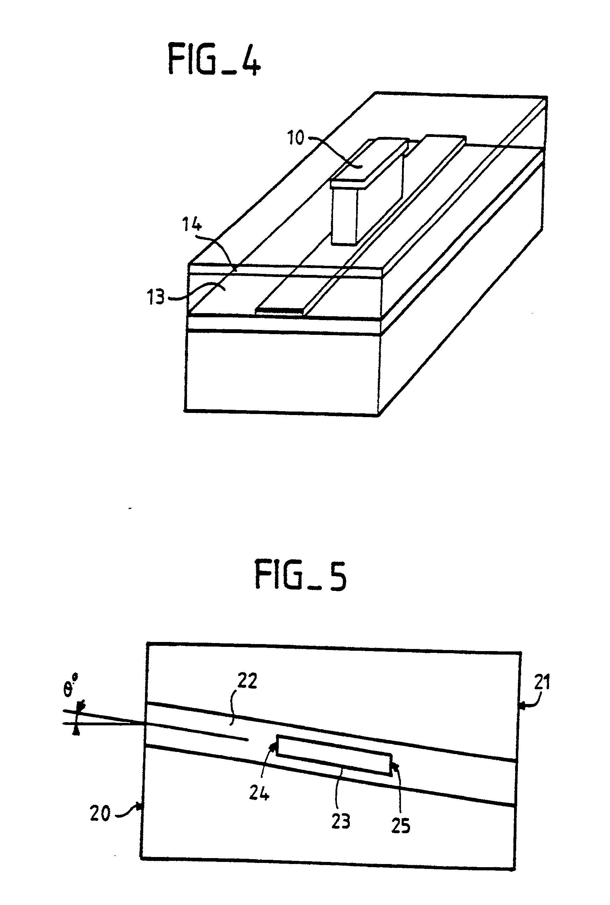

De plus, comme nous l'avons dit précédemment, cette structure permet d'obtenir un faible coefficient de réflexion modal aux faces clivées à condition pour ce faire d'incliner, comme cela est représenté en figure 5, l'axe du guide optique 22 et de l'élément amplificateur 23 par rapport à la perpendiculaire aux faces 20 et 21.

Une estimation de ce coefficient de réflexion a été faite pour cette structure et par exemple, pour un angle de 4°, le coefficient de réflexion est de l'ordre de $10^{-4}$ ce qui est déjà difficile à obtenir par les traitements anti-reflets classiques.

L'inclinaison de l'axe du guide optique 22 et de l'élément amplificateur 23, d'un angle θ par exemple, est obtenu en inclinant les masques 10 puis 11 par rapport aux faces clivées 20 et 21 lors des opérations de gravures précédentes.

De plus, selon l'invention, on prévoit que les faces 24 et 25 de l'élément amplificateur 23 sont également inclinées par rapport à l'axe de l'élément amplificateur. Préférentiellement, ces faces 24 et 25 sont parallèles aux faces clivées 20 et 21. Cela est obtenu en réalisant le masque 10 ayant une forme appropriée telle que représentée par la vue de la figure 5.

Selon une variante du procédé de réalisation les couches guidantes 3 et 5 ainsi que la couche active 7 sont réalisées sous la forme de couches alternées différentes de façon à constituer des multi-puits quantiques.

Le dispositif obtenu par le procédé de l'invention se présente sous une forme telle que représentée en figure 6.

Il comporte, sur un substrat 1, un guide d'onde constitué par la couche ou bande de guidage 5 et la couche 2, ces deux couches étant séparées par la couche d'arrêt d'attaque chimique 4.

Le matériau constituant les couches de ce guide doit avoir une largeur de bande interdite supérieure à l'énergie de l'onde propagée.

Sur le guide d'onde ainsi constitué est situé un élément d'amplification 7 en matériau présentant un maximum de sa courbe de gain adaptée à la longueur de l'onde à amplifier.

L'élément d'amplification 7 porte une couche 8 d'un matériau permettant une injection de courant électrique tel que l'InP dopé P.

L'ensemble de la structure est noyée dans une couche 13 d'un matériau semi-isolant.

La face supérieure de la couche 8 est munie d'une couche de contact ohmique 9.

Enfin, le substrat 1 comporte une couche de contact ohmique 16 permettant une commande électrique de la structure.

Conformément à la variante du procédé de réalisation décrite précédemment, les couches guidantes 3 et 5 ainsi que la couche active 7 se présentent sous la forme de couches alternées de matériaux différents de façon à constituer des multi-puits quantiques.

Le procédé de l'invention est applicable à un amplificateur dont l'élément amplificateur possède une structure DFB (Distributed Feed-back ou à résonateur distribué). Pour cela, après avoir réalisé la couche active 7, on réalise, à la surface supérieure de la couche active 7, un résonateur à réseau distribué par tout moyen connu dans la technique. Le procédé se poursuit ensuite comme cela a été décrit précédemment.

Le procédé de l'invention permet également de réaliser un modulateur en prévoyant la réalisation, avant le dépôt du matériau des couches 13 et 14, d'au moins une électrode et de connexions électriques pour l'application d'un champ électrique à la structure.

De la même façon, le procédé de l'invention est applicable à la réalisation de commutateurs. Pour cela, plusieurs guides d'ondes sont réalisés sur le substrat de façon à ce qu'ils possèdent des zones de couplage permettant de coupler entre eux les guides d'ondes. Des électrodes sont réalisées dans ces zones de couplage selon les techniques connues et permettent la commutation d'un faisceau lumineux d'un guide d'onde sur un autre. On obtient ainsi un commutateur sur lequel il est possible d'avoir, comme cela est schématisé sur la figure 7, des éléments amplificateurs 30, 31, 32, 33 sur différentes branches 40, 41, 42, 43 du commutateur.

Enfin, le procédé de l'invention est également applicable à la réalisation d'un répartiteur selon lequel plusieurs guides optiques sont interconnectés comme cela est représenté en figure 8. Différentes sections de guides d'onde peuvent être munies d'éléments amplificateurs 50 à 54 réalisés selon le procédé de l'invention comme décrit précédemment.

En résumé, nous proposons une structure nouvelle permettant l'intégration d'un amplificateur avec un guide d'onde et par là même ouvrant la voie à l'intégration de composants plus complexes.

La structure selon l'invention peut être réalisée avec des matériaux semiconducteurs de différents types, en particulier les composés III-V et leurs solutions solides telles que GaInAs, GaAlAs, GaInAlAs, GaInAsSb. etc...

## Revendications

1. Procédé de réalisation d'un dispositif optoélectronique amplificateur caractérisé en ce qu'il comporte les étapes suivantes :
    a) une étape d'épitaxie sur un substrat (1) des couches suivantes :
       – une couche de confinement (2) optique;
       – une première couche guidante optique (3) en matériau transparent à la longueur d'onde à amplifier ;
       – une première couche d'arrêt d'attaque chimique (4) ;
       – une deuxième couche guidante optique (5) ;
       – une couche active (7) dont le matériau présente un maximum de courbe de gain pour l'énergie de l'onde à amplifier ;
       – une couche de confinement (8) optique;
       – une couche de contact (9).
    b) une première étape de gravure d'au moins un élément amplificateur dans la couche active (7), la couche de confinement (8) et la couche de contact (9) ;
    c) une deuxième étape de gravure d'au moins un guide optique situé sous l'élément amplificateur, cette gravure se faisant dans la deuxième couche guidante optique (5) ;
    d) une étape de dépôt d'un matériau semi-isolant (13, 14) sur la structure ;
    e) une étape de réalisation d'un contact électrique sur la partie supérieure de la couche de contact (9).

2. Procédé selon la revendication 1, caractérisé en ce qu'une deuxième couche d'arrêt d'attaque chimique (6) est réalisée entre la deuxième couche guidante (5) et la couche active 7 et que lors de la deuxième étape de gravure cette deuxième couche d'arrêt d'attaque chimique est également gravée.

3. Procédé selon la revendication 1, caractérisé en ce que le guide d'onde optique relie deux faces (20, 21) de la structure obtenue, la première étape de gravure et la deuxième étape de gravure sont réalisées de façon à ce que l'élément amplificateur obtenu et le guide optique forment un angle différent de 90 degrés par rapport auxdites faces (20, 21).

4. Procédé selon la revendication 1 caractérisé en ce qu'il comporte au cours de l'étape d'épitaxie, après réalisation de la couche active (7), une phase de réalisation d'un résonateur distribué à la surface supérieure de la couche active (7).

5. Procédé selon la revendication 1, caractérisé en ce que l'étape de dépôt d'un matériau semi-isolant (13) comporte un dépôt d'une couche d'un matériau de blocage d'impuretés (14) sur le matériau semi-isolant (13).

6. Procédé selon la revendication 1, caractérisé en ce qu'au cours de l'étape d'épitaxie, la première couche guidante (3), la deuxième couche guidante (5) et la couche active (7) sont réalisées sous la forme de couches alternées constituant des multi-puits quantiques.

7. Amplificateur optique caractérisé en ce qu'il comporte un guide d'onde (5, 6) de largeur de bande interdite supérieure à l'énergie de l'onde à amplifier, ainsi qu'un élément amplificateur (7, 8) de dimensions limitées, situé sur une zone du guide d'onde et réalisé en un matériau dont le maximum de la courbe de gain correspond à l'énergie de l'onde propagée.

8. Amplificateur optique selon la revendication 7, caractérisé en ce que l'élément amplificateur (7, 8) est séparé du guide d'onde par une couche d'arrêt d'attaque chimique (6) dont l'épaisseur et la nature du matériau n'ont quasiment pas d'incidence sur le comportement optique de la structure composite ainsi formée.

9. Amplificateur optique selon la revendication 7, caractérisé en ce que le guide d'onde (5, 3) relie deux face (20, 21) opposées de la structure et forment un angle différent de 90 degrés par rapport à chacune de ces deux faces.

10. Amplificateur optique selon la revendication 7, caractérisé en ce que l'élément amplificateur est orienté selon l'axe principal du guide d'onde et qu'il possède deux faces (24, 25) situées selon cet axe et formant un angle différent de 90 degrés par rapport à cet axe.

11. Amplificateur optique selon la revendication 7, caractérisé en ce que le guide d'onde (5, 6) et l'élément amplificateur (7, 8) comportent des couches alternées de matériaux différents formant des multi-puits quantiques.

12. Procédé de réalisation d'un modulateur appliquant le procédé de la revendication 1, caractérisé en ce qu'il comporte avant l'étape de dépôt du matériau semi-isolant (13, 14) sur la structure, une étape de réalisation d'au moins une électrode et des moyens de connexions électriques à cette électrode de façon à permettre l'application d'un champ électrique au guide d'onde.

13. Procédé de réalisation d'un commutateur appliquant le procédé de la revendication 1, caractérisé en ce qu'il comporte la réalisation d'au moins deux guides d'ondes comportant des portions de couplage et la réalisation dans ces portions de couplage d'électrodes permettant l'application d'un champ électrique, un élément amplificateur étant réalisé au moins sur un des guides d'onde.

14. Procédé de réalisation d'un répartiteur appliquant le procédé de la revendication 1, caractérisé en ce qu'il comporte la réalisation de plusieurs guides d'onde agencés en "Y", un élément amplificateur pouvant être réalisé sur chaque branche du "Y".

## FIG_1-a

## FIG_1-b

## FIG_2

## FIG_3

FIG_6

9
8
15
14
13
4
3
16
7
5

FIG_7

40 30 32 42
41 31 33 43

FIG_8

52
51
53
50 54

## FIG_4

## FIG_5

EP 0 434 528 A1

**Office européen des brevets**

# RAPPORT DE RECHERCHE EUROPEENNE

Numero de la demande

EP 90 40 3603

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-4 054 363 (YASUHARU SUEMATSU) * Colonne 4, lignes 47-64; figures 5,10,16 * | 1,3,7,9 | H 01 L 33/00 H 01 S 3/25 H 01 S 3/085 |
| A | EP-A-0 240 400 (THOMSON-CSF) * Page 4, ligne 18 - page 8, ligne 8; figures 5-19 * | 1,7,8 | |
| D,A | ELECTRONICS LETTERS, vol. 25, no. 16, août 1989, pages 1048-1049, Stevenage, Herts, GB; N.A. OLSSON et al.: "Polarisation-independent optical amplifier with buried facets" * Page 1048; figure 1 * | 1 | |
| A | EP-A-0 178 497 (SIEMENS AG) * Colonne 2, ligne 36 - colonne 3, ligne 35; figures 1-4 * | 1,4,7,8 | |
| A | ELECTRONICS LETTERS, vol. 24, no. 20, 29 septembre 1988, pages 1275-1276, Stevenage, Herts, GB; C.E. ZAH et al.: "1.3 mum GaInAsP near-travelling-wave laser amplifiers made by combination of angled facets and antireflection coatings" * Page 1275; figure 1 * | 7,9,10 | DOMAINES TECHNIQUES RECHERCHES (Int. Cl.5) H 01 S |
| A | APPLIED PHYSICS LETTERS, vol. 51, no. 20, 16 novembre 1987, pages 1577-1579, American Institute of Physics, New York, US; H. INOUE et al.: "Optical amplification by monolithically integrated distributed-feedback lasers" * Page 1577; figure 1 * -/- | 1,13 | |

Le présent rapport a été établi pour toutes les revendications

| Lieu de la recherche | Date d'achèvement de la recherche | Examinateur |
|---|---|---|
| LA HAYE | 28-02-1991 | GNUGESSER H.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)

10

Office européen
des brevets

**RAPPORT DE RECHERCHE EUROPEENNE**

Numero de la demande

EP 90 40 3603

| | DOCUMENTS CONSIDERES COMME PERTINENTS | | |
|---|---|---|---|
| Catégorie | Citation du document avec indication, en cas de besoin, des parties pertinentes | Revendication concernée | CLASSEMENT DE LA DEMANDE (Int. Cl.5) |
| P,X | WO-A-9 008 411 (BRITISH TELECOMM. PLC) * Page 13, lignes 9-27; revendications 1-3; figures 1,2 * ----- | 7 | |
| | | | DOMAINES TECHNIQUES RECHERCHES (Int. Cl.5) |

Le présent rapport a été établi pour toutes les revendications

| Lieu de la recherche | Date d'achèvement de la recherche | Examinateur |
|---|---|---|
| LA HAYE | 28-02-1991 | GNUGESSER H.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)